# EUROPEAN PATENT SPECIFICATION

(11) **EP 1 404 507 B1**
(45) Date of publication and mention of the grant of the patent: **03.06.2009**
(21) Application number: 02743307.7
(22) Date of filing: 20.06.2002
(51) Int. Cl.: B29C 51/08, H05B 33/10

(54) **OLED FILM AND METHOD FOR ITS FORMING**
OLED-FOLIE UND VERFAHREN ZU IHRER HERSTELLUNG
STRUCTURE OLED ET PROCEDE POUR SA PRODUCTION

(30) Priority: 06.07.2001 FI 20011483
(43) Date of publication of application: 07.04.2004
(73) Proprietor: VALTION TEKNILLINEN TUTKIMUSKESKUS, 02150 Espoo (FI)
(72) Inventor: MÄKELÄ, Tapio, FIN-00740 Helsinki (FI); ISOTALO, Heikki, FIN-01300 Vantaa (FI); LAPPALAINEN, Jukka, FIN-00920 Helsinki (FI)
(74) Representative: Stellberg, Hans Valter
(86) International application number: PCT/FI2002/000547
(87) International publication number: WO 2003/004252

(56) References cited:
- EP-A2- 1 065 737
- WO-A1-01/84584
- US-A- 5 806 389
- US-A- 5 970 318
- US-A- 6 046 543

## Description

The object of the present invention is an OLED film according to the preamble of Claim 1.

The object of the present invention is also a method for forming an OLED film according to the preamble of Claim 4.

The invention relates to organic light emitting diode structures (OLED) which are used, for example, in passive and active matrix displays. An OLED film is usually formed by evaporating OLED layers onto a substrate. OLED layers typically comprise a first electrode, a layer of emitting material and a second electrode as well as intermediate and protective layers. OILED layers may be formed so that they cover the whole substrate, or so that they will form several different OLED components or OLED areas on the substrate.

From layer-structured OLED structures, one may form large consistent plane surfaces which endure bending so that they can be formed into evenly curved surfaces. Thus, from a plane OLED structure, one is able to form, for example, a curved surface which follows the cylindrical surface below it. The OLED structure deflects thus only to the direction of the cylindrical surface perimeter, whereas the material structure of electrodes in the OLED structure remains unbroken. Then the electrical conductivity of electrodes in the direction of the plane surface is maintained. Such structures may be used in, for example, background lighting.

The FI patent application 981731 presents an OLED structure in which the light emitting layer between the electrodes is sol gel glass, into which one has chemically inserted material with an effect on the opto-electric characteristics.

The EP patent publication 1065737 presents an OLED structure in which an electron hole injecting layer has been placed between the anode and the light emitting layer. On the other hand, an electron-emitting layer has been placed between the cathode and the light emitting material.

The US patent 5,970,318 presents a structure which endures mechanical bending and consists of an OLED and a transistor, and which may be used in flexible displays. This OLED comprises a transparent electrode formed on a substrate, an organic light emitting layer formed on the electrode, and an upper electrode formed on the emitting layer.

The US patent 6,046,543 presents a reversed OLED structure. This structure comprises a substrate, a polymer layer on top of the substrate, a cathode on top of the polymer layer, an electron transporting layer on top of the cathode, a light emitting layer on top of the electron transporting layer, a hole transporting layer on top of the light emitting layer, a protective layer on top of the hole transporting layer, and an anode on top of the protective layer.

According to the preconception of the persons skilled in the art, a layer-structured OLED structure does not remain unbroken and functional if a plane OLED structure is bent in the direction of several axes pointing to different directions in the plane surface. Thus, according to the preconception of the persons skilled in the art, one has not been able to form areas ascended from the level surface into the plane OLED surface, for instance hemispherical areas. This matter has limited the use of the OLED structure in applications in which one could use plane surfaces, and such plane surfaces which curve in the direction of the perimeter of cylindrical surface. OLED structures were not usable in such objects in which the OLED structure should be formed on a surface bending in the direction of several axes, such as on hemisphere.

According to the preconception of the persons skilled in the art, one has also not been able to form plane OLED structures into pieces of desired shape by cutting, because the anode and the cathode of the OLED stricture were considered to short circuit at the cutting point. Because the thickness of the OLED layers formed on the substrate is only approximately 50 nm, it has been thought that the anode and the cathode will inevitably be in touch with each other at the cutting point

In principle, an OLED area ascended from a plane OLED surface could be constructed directly by coating OLED layers on a non-flat surface, for example on a hemisphere, but this option is not practical or productive. Then, the non-flat surface which is coated by evaporation should be rotated during coating. In addition, it is difficult to form an even coating on a non-flat rotating surface.

In the present invention, it was noticed contrary to the preconceptions of the persons skilled in the art that ascended OLED areas may be formed on a plane OLED structure so that the functionality of the OLED structure is maintained.

In the present invention, it was also noticed contrary to the preconceptions of the persons skilled in the art that pieces of desired shape may be cut from a plane OLED structure so that the functionality of the OLED structure is maintained.

The principal characteristics of the OLED film according to the invention are presented in the characterising part of Claim 1.

The principal characteristics of the method according to the invention are presented in the characterising part of Claim 4.

With the method according to the invention, an ascended area or ascended areas, such as hemispherical areas, may be formed on a plane OLED film, which comprises a substrate and OLED layers formed on it. This structure is produced by forming an OLED known *per se,* which endures forming, temperature loading and mechanical stress, with forming methods known *per se* which are suited for forming plastic-like materials, such as vacuum forming, pressure forming, matched-mould forming or their combination in a plastic forming machine. With an OLED film thus produced, one is able to, for example, generate light on a surface of desired shape or use the produced structure for patterning purposes. One may thus utilise an unused non-flat surface or space in, for instance, portable electronics products. Other possible applications for structures according to the invention are, for example, integrated background lights in different consumer goods, such as watches.

The forming may be done so that only the OLED film is formed, after which the formed OLED film is inserted as a part of the product in which one wishes to utilise the light generated by the OLED component.

The forming may also be done so that the OLED film is formed together with the product the part of which one wishes the OLED film to become. This could be, for instance, a situation in which one wishes the OLED film to be a part of a plastic piece. Then the OLED film is combined to a plastic blank and both parts are formed together in a plastic forming process.

In vacuum forming, the plane OLED film is placed over a mould and fastened from its edges to the mould. After this, vacuum is produced to the space between the mould and OLED film, whereas the OLED film sticks onto the surfaces of the mould. Thus, the OLED film is formed to the shape defined by the mould surfaces.

In pressure forming, the plane OLED film is placed over a mould and fastened from its edges to the mould. The mould is closed with a sealing cover, after which pressure is lead to the space between the cover and the OLED film, whereas the pressure presses the OLED film firmly onto the mould surfaces. The OLED film is thus formed to the shape defined by the mould surfaces. The removal of air from the space between the OLED film and the mould must be arranged. Forming may further be intensified by producing a vacuum in the space between the OLED film and the mould. Then, the vacuum below the OLED film sucks the OLED film closely onto the mould surfaces, and the pressure above the OLED film presses the OLED film closely onto the mould surfaces.

In matched-mould forming, the OLED film is placed over a female mould and fastened from its edges to the mould. After this, the OLED film is pressed with a male mould into the female mould, wheres the OLED film between the moulds is formed into the shape defined by the moulds.

In all above-mentioned forming methods, the OLED film is usually preheated into an appropriate temperature before forming, when the forming qualities of the OLED film are improved. Because high temperatures age the OLED film, the heating phase should be short and the used temperature as low as possible. The significance of this problem will constantly decrease as OLED films improve and become more stabile.

The forming according to the invention, in which the starting point is a plane substrate, into which one has formed one consistent or several separate OLED components, applies extremely well into mass production. The fabrication of a plane film which includes OLEDs is economical and effective, and also forming a ready-made OLED film in the plastic forming process is economical and effective.

The- invention will now be explained in more detail with reference, to the accompanying drawings, but not limiting the invention to only such details.

Figure 1 illustrates a diagrammatic cross section of an OLED structure.

Figure 2 illustrates a diagrammatic cross section of an OLED structure formed from Figure 1 according to the invention.

Figure 3 illustrates the contour lines of a formed OLED component illustrated in Figure 2.

Figure 4 illustrates a diagrammatic cross section of an alternative OLED structure.

Figure 5 illustrates one possibility to arrange the electrode connections of an OLED component onto the same level.

Figure 6 illustrates a modification of the structure in Figure 5.

Figure 7 illustrates a situation in which several separate OLED components have been placed on one substrate.

Figure 8 illustrates a situation in which the OLED structure is formed of a combination of two separate films.

Figure 9 illustrates an alternative situation in which several separate OLED components have been placed on one substrate.

Figure 10 illustrates the results of a test in which the luminance of an OLED component formed according to the invention was measured as a function of the voltage.

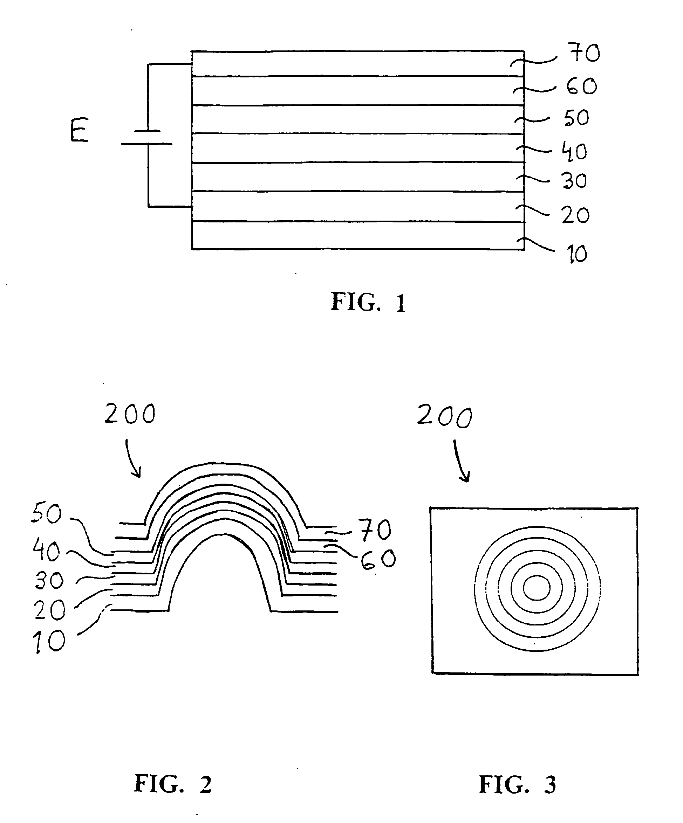

Figure 1 illustrates an example of an OLED structure formed of several layers. The OLED layers were formed on a substrate 10, and they comprise a first electrode 20 on top of the substrate 10, a hole injecting layer, or electrically conductive polymer layer 30, on top of the first electrodes 20, a hole transporting layer 40 on top of the electrically conductive polymer layer 30, a light emitting layer 50 on top of the hole transporting layer 40, an electron transporting layer 60 on top of the light emitting layer 50, and a second electrode 70 on top of the electron transporting layer 60. The power supply E which supplies voltage for the OLED structure is connected so that the positive pole of the power supply E is connected to the first electrode 20, or anode, and the negative pole of the power supply E is connected to the second electrode 70, or cathode. The structure illustrated in Figure 1 may be a matrix display element the size of one pixel, or it may be a large surface which is used for background lighting.

In the structure of Figure 1, light is directed from the light emitting layer 50 through the hole transporting layer 40, the hole injecting layer 30, the first electrode 20 and the substrate 10 beneath it. Thus, the layers 10, 20, 30, 40 below the light emitting layer 50 must transmit light. Naturally, the situation may also be reversed so that light is directed through the second electrode 70.

The material of the substrate 10 is flexible and endures forming. Suitable materials are, for example, polyethylene terephthalate (PET), polyester (PE), polycarbonate (PC), polypropylene (PP), acrylate, amorphous glass or a combination PC/PE. The substrate may also be formed of an electrically conductive polymer film, for example, polyaniline (PANI) or polytiophene (PT) or their derivates. The thickness of the substrate layer 10 is normally within the range 10-1000 µm, advantageously within the range 10-200 µm.

The first electrode 20, or anode, must be chosen so that it endures forming. Suitable materials are, for example, indium tin oxide (ITO), polyaniline (PANI) or a thin transparent metal film. ITO's transparency is usually in the range of 80-95%. The thickness of the first electrode 20 is normally approximately 50 nm.

As the hole injecting, that is, electrically conductive polymer layer 30, one may use for example polytiophene (PT) and its derivates or polyaniline (PANI) and its derivates. The thickness of the electrically conductive polymer layer 30 is normally approximately 50 nm.

The hole transferring layer 40 may be for example N,N'-diphenyle-N,N-bis(3-methylphenyle)-1,1'-bifenyle-4,4'-diamine, that is TPD. The thickness of the hole transferring layer 40 is normally approximately 50 nm.

The light emitting layer 50 may be, for example, of semiconducting organic materials, such as polymers and molecules the molecular orbital structure of which enables exciting the electrons into higher excitation which is then discharged as electromagnetic radiation. Such materials are, for instance, tri(8-hydroxyquinoline)aluminium (III), that is, Alq and poly-(2- methoxy-5-(2'-ethylhexyloxy)-1,4-phenylenevinylene), that is MEH-PPV. The thickness of the light emitting layer 50 is normally approximately 60 nm.

The electron transferring layer 60 may be formed, for example, of compounds LiF or CsF. The thickness of the electron transferring layer 60 is normally only approximately 0.8 nm. This electron transferring layer functions as a sort of protective layer, and it prevents the light emitting layer 50 from interacting destructively with the OLED.

The second electrode 70, or cathode, may be formed of a metal. Suitable metals are aluminium (Al), magnesium/silver (Mg/Ag), calsium (Ca), lithium (Li), gold (Au) and copper (Cu) or a combination of them. The thickness of the second electrode 50 is normally approximately 50 nm.

With the above mentioned materials, one is able to produce a formable OLED structure. With the electrically conductive polymer 30 on the anode 20, the electrical conductivity of the anode 20 is secured in a horizontal direction in a situation, in which the anode 20 is degraded. The electrically conductive polymer 30 then vertically forms an electricity conductive bridge between the degraded electrode areas. After forming, both the anode 20 and the cathode 70 may be degraded, but still preserve their functionality.

The forming properties of the OLED structure may also be improved by inserting a substrate film with good forming properties below the substrate 10.

Figures 2 and 3 illustrate an OLED component according to the invention, which is formed into an area 200, which is ascended from the plane surface, with a plastic forming method known *per se.* Figure 3 illustrates the contour lines of the OLED component illustrated in Figure 2 from a top view. Figures 2 and 3 illustrate corresponding structure layers with Figure 1.

The OLED area which is ascended from the plane surface may be, for example, hemispherical. The OLED area ascended from the plane surface is constructed by forming the plane OLED film in a plastic forming process by vacuum forming, pressure forming or compression forming, and by cutting the formed piece into desired shape if necessary. The cutting may be performed, for example, with cutters or a die cutting method. The structure layers of the OLED film must maintain their functionality in the forming so that the electrodes 20, 70 are still conductive and the light emitting layer 50 maintains its emitting capability.

The OLED film may be fabricated so that the light emitting area forms a desired plane pattern. This may be accomplished in the context of the OLED film fabrication so that, for example, the light emitting layer 50 is formed in the shape of a certain pattern. The ready-made plane OLED film may also be cut into the desired shape. After this, the patterned OLED film may be formed with a plastic forming method known *per se* so that one forms areas ascended from the plane surface into it. When one applies injection moulding in the fabrication, one is also able to produce packaging or protection for the product.

The OLED structure with forming properties enables the fabrication of a formable OLED film or roll, and its insertion into an already formed product.

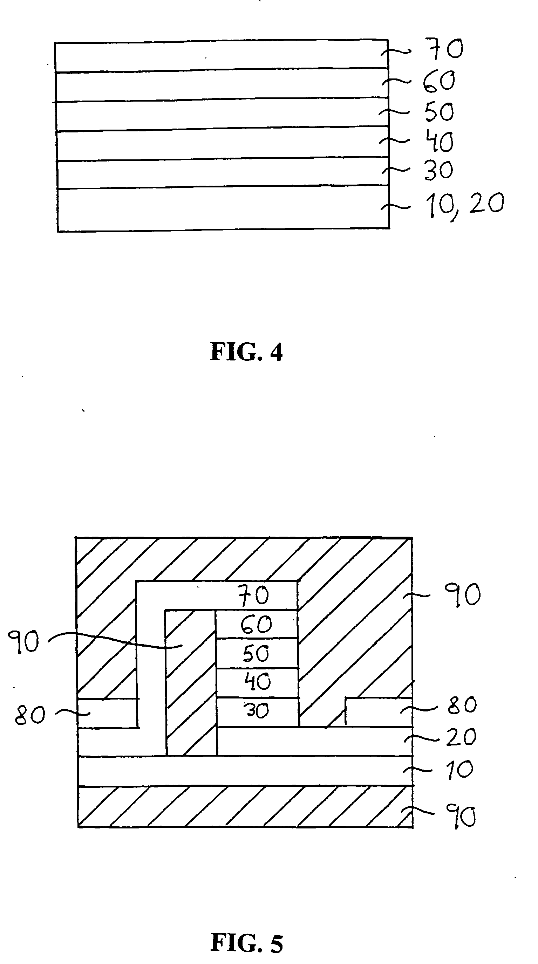

Figure 4 illustrates an alternative OLED structure. In this alternative, the substrate 10 and the first electrode 20 have been combined into one layer. The substrate 10 is then of a netlike material, into which electrically conductive polymer has been impregnated as the anode. The netlike substrate material may be comprised of, for example, paper, and the anode material may be for instance PANI.

Figure 5 illustrates a possibility to arrange the electrode connections of an OLED component on the same level. The second electrode 70 has here been brought down onto the substrate 10, whereas the connections of the first electrode 20 and the second electrode 70 are located primarily on the same level. The electrodes 20, 70 were each connected into its own conductor film 80, with the aid of which the power supply may be connected to the structure. The conductor film may be PANI, Ag or Au. The figure shows also a covering 90, with which the structure is protected. The protective material 90 may be comprised of polymer layers, for example, of acrylate, which are evaporated in vacuum over the OLED structure and below the substrate layer 10 for protection.

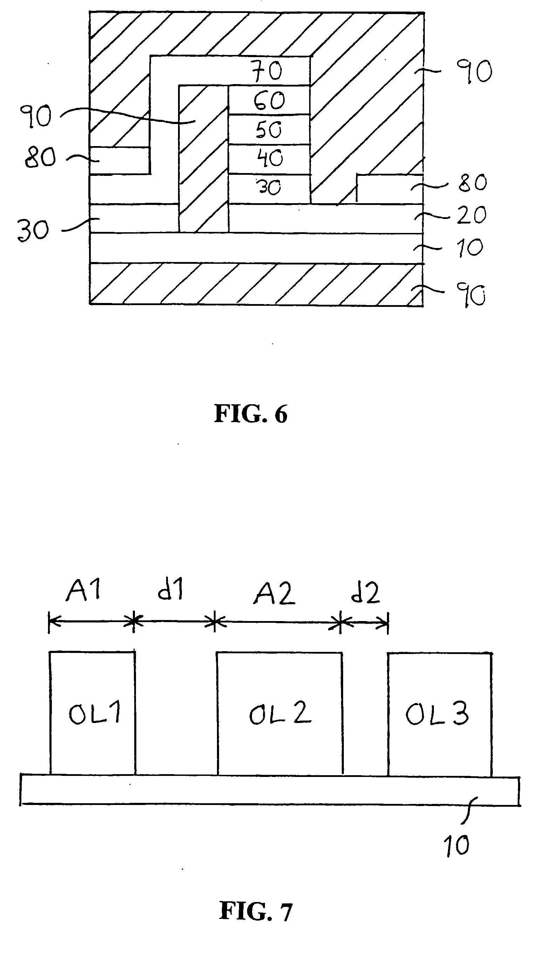

Figure 6 illustrates an alternative for the structure illustrated in Figure 5. In this alternative, the electrically conductive polymer layer 30 has also been arranged between substrate 10 and the horizontal part of the down-brought cathode 70. This way the bending properties of the area outside the actual OLED component may be improved.

Figure 7 illustrates a situation in which several separate OLED components OL1, OL2, OL3 have been formed over a shared substrate 10. Each OLED component OL1, OL2, OL3 comprises here the layer structure, or an anode 20, an electrically conductive polymer layer 30, a hole transferring layer 40, a light emitting layer 50, an electron transferring layer 60 and a cathode 70 mentioned above in Figures 1, 4, 5 and 6. The distance d1, d2 of each OLED component from the next OLED component may vary depending on the requirements, and the surface area A1, A2 and shape of each OLED component may also vary depending on the requirements. This way a desired pattern composed of separate OLED components may be formed on the shared substrate 10. With such structure, the forming properties of the OLED film may further be improved. The areas between the OLED components OL1, OL2, OL3 may be formed with extensive force, for example so that one forms sharp 90-degree folds into the points in question, and one exerts lighter forming onto areas including OLED components OL1, OL2, OL3. Each OLED component OL1, OL2, OL3, the anodes 20 and the cathodes 70 may be connected to the power supply or supplies, either so that all OLED components OL1, OL2, OL3 are controlled simultaneously or so that each OLED component OL1, OL2, OL3 is controlled separately. For instance, OLED components OL1, OL2, OL3 may form a ring pattern so that OL1 forms the innermost ring, OL2 forms the next ring and OL3 the outmost ring.

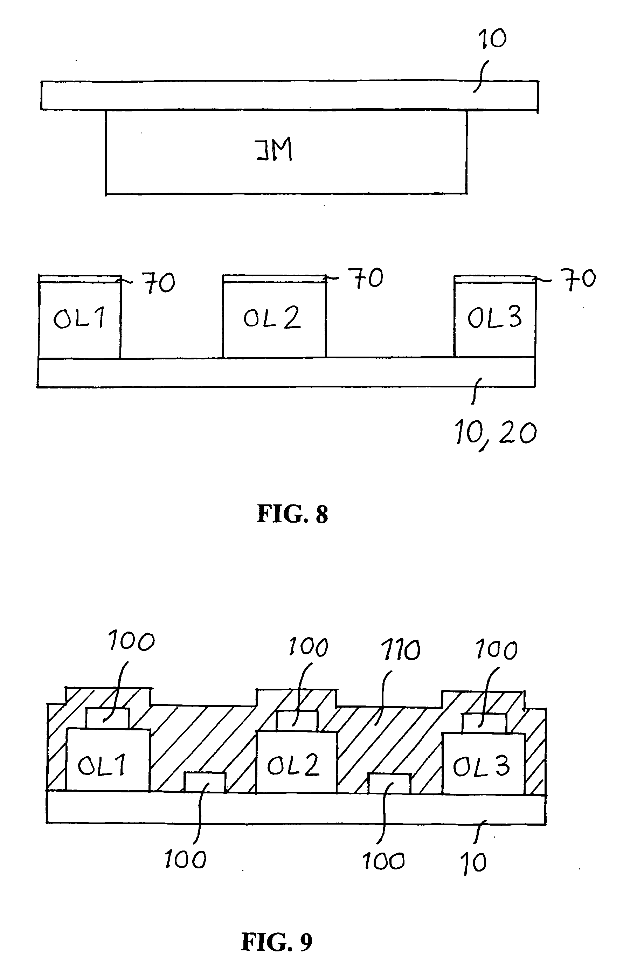

Figure 8 illustrates a situation in which, like in Figure 7, several separate OLED components OL1, OL2, OL3 are formed over a shared substrate 10. Over the substrate 10 or in the substrate 10 itself, one shared anode 20 was also formed. In addition to this, an area of electrically conductive material JM was formed over the second substrate 10. When the structures are combined, the electrically conductive material area JM settles on top of the cathodes 70 on top of the OLED components OL1, OL2, OL3, and form an electric connection between the mentioned cathodes 70. After combining an OLED structure is produced, in which there are several separate OLED components OL3, OL2, OL3 so that all OLED components are controlled via the shared anode 20 and the shared cathode 70. The electrically conductive material JM may be Al, Au, Ag or an electrically conductive polymer, such as PANI, or a combination of them, such as Ag+PANI. The situation may naturally be arranged as such that only specified OLED components are combined with the electrically conductive material JM. This way one may form a desired pattern or desired patterns of OLED components, which may be controlled separately.

Figure 9 illustrated a situation in which oxygen and/or moisture removing material 100 was inserted on OLED areas OL1, OL2, OL3 and/or between them. This arrangement is also protected with a laminate film 110.

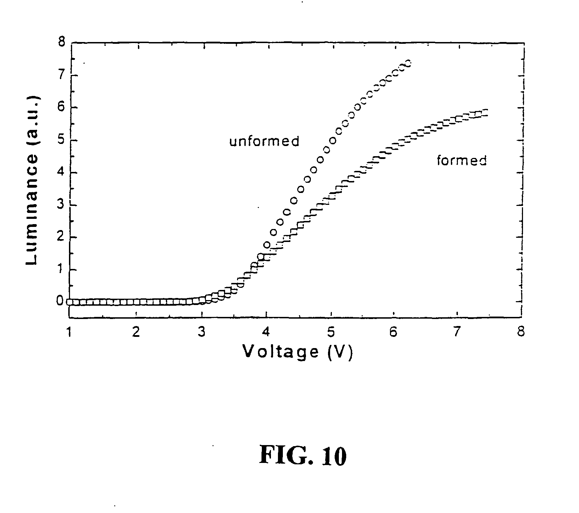

Figure 10 illustrates the results of a test in which the luminance of the OLED component according to the invention was measured as a function of voltage. The luminance is presented on the Y axis in relative units (a.u., arbitrary units). The measurements of the unformed OLED structure are illustrated with circles, and the measurements of the formed OLED component are illustrated with squares. In the tests made, it was observed that after forming the luminance of the OLED structure decreased only approximately 10-20%, that is, the luminance is sufficient enough for many kinds of applications. Reasons for the decrease of luminance are for instance the degrading of the first electrode 20 or the ITO layer during forming, a change in the emitting layer 50 during thermal treatment, and a change in the dimensions of the whole structure. Thus, the micro cracks invisible to the eye, which were produced during forming, do not make the product totally inoperative. Vacuum forming was used in this test, the temperature was within the range of 100-170 °C and the forming time was approximately 3 minutes.

An OLED structure according to the invention may be adapted into a desired supply voltage, for example into the range of 1-5V generally used in mobile phones. Within this range, the power supply may be, for example, batteries manufactured by a printing method, which are known for instance from US patent 5,652,043*.*

The products fabricated with the method according to the invention are of simple design, whereas their fabrication is economical, and they apply well, for example, for consumer products.

The scope of the invention is defined by the following claims.

## Claims

1. An OLED film is formed of at least one layer-structured OLED component (OL1, OL2, OL3) formed on a substrate (10), which OLED component comprises a first electrode (20), an electrically conductive polymer (30), a light emitting material (40) and a second electrode (50), as well as intermediate and protective layers (40, 60, 80, 90, 100, 110), **characterised in that** the said at least one OLED component (OL1, OL2; OL3) comprises at least one OLED area ascended from the plane film.

2. An OLED film according to Claim 1, **characterised in that** one consistent layer-structured OLED component which covers the whole substrate (10) is formed on the substrate (10), and that the said OLED component comprises at least one OLED area ascended from the plane film.

3. An OLED film according to Claim 1, **characterised in that** at least two separate layer-structured OLED components (OL1, OL2, OL3) are formed on the substrate (10), and that at least one of these OLED components (OL3, OL2, OL3) comprises at least one OLED area ascended from the plane film.

4. A method for forming an OLED film according to claim 1, comprising forming at least one layer-structured plane OLED component (OL3, OL2, OL3) on a plane substrate (10) with a method know *per se,* which OLED component comprises a first electrode (20), an electrically conductive polymer (30), a light emitting material (50) and a second electrode (70), as well as intermediate and protective layers (40, 60, 80, 90, 100, 110), **characterised by** forming the plane OLED film comprising the substrate (10) and the at least one OLED component (OL1, OL2, OL3) in a plastic forming process know *per se* by using vacuum, pressure, compression or a combination of these so that at least one OLED area ascended from the plane OLED component (OL1, OL2, OL3) being formed on the plane OLED film

5. A method according to Claim 4, **characterised by** forming one consistent layer-structured OLED component which covers the whole substrate (10) on the substrate (10), and by foaming the thus formed plane OLED film is formed in a plastic forming process know *per se* by using vacuum, pressure, compression or a combination of these so that at least one OLED area ascended from the plane OLED component (OL1, OL2, OL3) being formed in the plane OLED film.

6. A method according to Claim 1, **characterised by** forming at least two separate layer-structured OLED components (OL1, OL2; OL3) on the substrate (10), and by forming the thus formed plane OLED film in a plastic forming process known *per se* by using vacuum, pressure, compression or a combination of these so that at least one OLED area ascended from the plane OLED component (OL1, OL2, OL3) being formed in the plane OLED film.

7. A method according to one of Claims 4-6, **characterised by** forming the formed layer-structured plane OLED film together with a plane plastic piece in a plastic forming process known *per se* by using vacuum, pressure, compression or a combination of these so that the substrate (10) and the OLED film are formed as a part of the plastic piece, and at least one OLED area ascended from the plane structure being formed in the combined OLED and plastic piece structure.

8. A method according to one of Claims 4-7, **characterised by** cutting the OLED film formed in the plastic forming process is cut to desired shape with cutters or a die cutting method while maintaining the functionality of the OLED film.

## Patentansprüche

1. OLED-Folie, welche aus zumindest einem geschichteten OLED-Bauteil (OL1, OL2, OL3) ausgebildet ist, welches auf einem Substrat (10) ausgebildet ist, wobei das OLED-Bauteil eine erste Elektrode (20), ein elektrisch leitfähiges Polymer (30), ein Lichtemissionsmaterial (40) und eine zweite Elektrode (50), als auch Zwischen- und Schutzschichten (40, 60, 80, 90, 100, 110) enthält, **dadurch gekennzeichnet, dass** das zumindest eine OLED-Bauteil (OL1, OL2, OL3) zumindest einen OLED-Bereich enthält, welcher von der Flächenfolie hervorsteht.

2. OLED-Folie nach Anspruch 1, **dadurch gekennzeichnet, dass** ein einheitlich geschichtetes OLED-Bauteil, welches das gesamte Substrat (10) bedeckt, auf dem Substrat (10) ausgebildet ist, und dass das OLED-Bauteil zumindest einen OLED-Bereich enthält, welches von dem Flächenfilm hervorsteht.

3. OLED-Folie nach Anspruch 1, **dadurch gekennzeichnet, dass** zumindest zwei separate geschichtete OLED-Bauteile (OL1, OL2, OL3) auf dem Substrat (10) ausgebildet sind, und dass zumindest eines von diesen OLED-Bauteilen (OL1, OL2, OL3) zumindest einen OLED-Bereich enthält, welcher von der Flächenfolie hervorsteht.

4. Verfahren zum Ausbilden von einer OLED-Folie nach Anspruch 1, welches ein Ausbilden von zumindest einem flächengeschichteten OLED-Bauteil (OL1, OL2, OL3) auf einem Flächensubstrat (10) durch ein an sich bekanntes Verfahren enthält, wobei das OLED-Bauteil eine erste Elektrode (20), ein elektrisch leitfähiges Polymer (30), ein Lichtemissionsmaterial (50) und eine zweite Elektrode (70), als auch Zwischen- und Schutzschichten (40, 60, 80, 90, 100, 110) enthält, **gekennzeichnet durch** ein Ausbilden der Flächen-OLED-Folie, welche das Substrat (10) und das zumindest eine OLED-Bauteil (OL1, OL2, OL3) enthält, in einem an sich bekannten plastischen Ausbildungsprozess unter Verwendung von Vakuum, Druck, Kompression oder einer Kombination dieser, so dass zumindest ein OLED-Bereich, welcher von dem Flächen-OLED-Bauteil (OL1, OL2, OL3) hervorsteht, auf der Flächen-OLED-Folie ausgebildet wird.

5. Verfahren nach Anspruch 4, **gekennzeichnet durch** ein Ausbilden von einem einheitlich geschichteten OLED-Bauteil, welches das gesamte Substrat (10) bedeckt, auf dem Substrat (10), und **durch** ein Ausbilden der somit ausgebildete Flächen-OLED-Folie, welche in einem plastischen Ausbildungsprozess, welcher an sich bekannt ist, unter Verwendung von Vakuum, Druck, Kompression oder einer Kombination dieser ausgebildet wird, so dass zumindest ein OLED-Bereich, welcher von dem Flächen-OLED-Bauteil (OL1, OL2, OL3) hervorsteht, in dem Flächen-OLED-Film ausgebildet wird.

6. Verfahren nach Anspruch 1, **gekennzeichnet durch** ein Ausbilden von zumindest zwei separat geschichteten OLED-Bauteilen (OL1, OL2, OL3) auf dem Substrat (10), und **durch** ein Ausbilden der somit ausgebildeten Flächen-OLED-Folie in einem plastischen Ausbildungsprozess, welcher an sich bekannt ist, unter Verwendung von Vakuum, Druck, Kompression oder einer Kombination von diesen, so dass zumindest ein OLED-Bereich, welcher von dem Flächen-OLED-Bauteil (OL1, OL2, OL3) hervorsteht, in der Flächen-OLED-Folie ausgebildet wird.

7. Verfahren nach einem der Ansprüche 4 bis 6, **gekennzeichnet durch** ein Ausbilden der ausgebildeten geschichteten Flächen-OLED-Folie zusammen mit einem Flächen-Kunststoffstück in einem plastischen Ausbildungsprozess, welcher an sich bekannt ist, unter Verwendung von Vakuum, Druck, Kompression oder einer Kombination dieser, so dass das Substrat (10) und die OLED-Folie als ein Teil von dem Kunststoffstück ausgebildet werden, und zumindest ein OLED-Bereich, welcher von dem Flächenaufbau hervorsteht, in dem zusammengefassten OLED- und Kunststoffstück-Aufbau ausgebildet wird.

8. Verfahren nach einem der Ansprüche 4 bis 7, **gekennzeichnet durch** ein Schneiden der OLED-Folie, welche in dem plastischen Ausbildungsprozess ausgebildet wird, auf eine gewünschte Form unter Verwendung von Abschneidvorrichtungen oder einem Ausstanzverfahren, während die Funktionalität von der OLED-Folie beibehalten wird.

## Revendications

1. Film OLED formé d'au moins un composant OLED structuré en couches (OL1, OL2, OL3) formé sur un substrat (10), lequel composant OLED comprend une première électrode (20), un polymère électriquement conducteur (30), un matériau électroluminescent (40) et une deuxième électrode (50), ainsi que des couches intermédiaires et de protection (40, 60, 80, 90, 100, 110), **caractérisé en ce que** ledit au moins un composant OLED (OL1, OL2 ; OL3) comprend au moins une zone OLED montée à partir du film plan.

2. Film OLED selon la revendication 1, **caractérisé en ce qu'**un composant OLED structuré en couches cohérent qui couvre la totalité du substrat (10) est formé sur le substrat (10) et **en ce que** ledit composant OLED comprend au moins une zone OLED montée à partir du film plan.

3. Film OLED selon la revendication 1, **caractérisé en ce qu'**au moins deux composants OLED structurés en couches (OL1, OL2, OL3) sont formés sur le substrat (10), au moins un des ces composants OLED (OL1, OL2, OL3) comprend au moins une zone OLED montée à partir du film plan.

4. Procédé pour former un film OLED selon la revendication 1, comprenant la formation d'au moins un composant OLED plan structuré en couches (OL1, OL2, OL3) sur un substrat plan (10) par un procédé connu en soi, lequel composant OLED comprend une première électrode (20), un polymère électriquement conducteur (30), un matériau électroluminescent (50) et une deuxième électrode (70), ainsi que des couches intermédiaires et de protection (40, 60, 80, 90, 100, 110), **caractérisé par** la formation du film OLED plan comprenant le substrat (10) et de l'au moins un composant OLED (OL1, OL2, OL3) dans un procédé de moulage plastique connu en soi, en utilisant le vide, la pression, la compression ou une combinaison de ceux-ci de manière qu'au moins une zone OLED montée à partir du composant OLED plan (OL1, OL2, OL3) soit formée sur le film OLED plan.

5. Procédé selon la revendication 4, **caractérisé par** la formation d'un composant OLED structuré en couches cohérent qui couvre la totalité du substrat (10) sur le substrat (10) et en ce que la formation du film OLED plan ainsi formé est réalisée dans un procédé de moulage plastique connu en soi, en utilisant le vide, la pression, la compression ou une combinaison de ceux-ci de manière qu'au moins une zone OLED montée à partir du composant OLED plan (OL3, OL2, OL3) soit formée dans le film OLED plan.

6. Procédé selon la revendication 1, **caractérisé par** la formation d'au moins deux composants OLED structurés en couches (OL3, OL2 ; OL3) sur le substrat (10) et par la formation du film OLED plan ainsi formé dans un procédé de moulage plastique connu en soi, en utilisant le vide, la pression, la compression ou une combinaison de ceux-ci de manière qu'au moins une zone OLED montée à partir du composant OLED plan (OL1, OL2, OL3) soit formée dans le film OLED plan.

7. Procédé selon l'une des revendications 4 à 6, **caractérisé par** la formation du film OLED plan structuré en couches formé conjointement avec une pièce plane en plastique dans un procédé de moulage plastique connu en soi, en utilisant le vide, la pression, la compression ou une combinaison de ceux-ci de manière que le substrat (10) et le film OLED soient formés comme une partie de la pièce en plastique, et au moins une zone OLED montée à partir de la structure plane soit formée dans la structure combinée OLED et pièce en plastique.

8. Procédé selon l'une des revendications 4 à 7, **caractérisé par** le découpage du film OLED formé dans le procédé de moulage plastique, au profil désiré avec des dispositifs de découpage ou un procédé de découpage à l'emporte-pièce tout en maintenant la fonctionnalité du film OLED.
